# EUROPÄISCHE PATENTANMELDUNG

(11) **EP 1 377 149 A2**
(43) Veröffentlichungstag der Anmeldung: **02.01.2004**
(21) Anmeldenummer: 03005172.6
(22) Anmeldetag: 07.03.2003
(51) Int. Cl.: H05K 9/00

(54) **Vorrichtung zum Schutz vor elektrostatischer Entladung und elektromagnetischer Einflüsse**

(30) Priorität: 26.06.2002 DE 10228633
(71) Anmelder: Fujitsu Siemens Computers GmbH, 81739 München (DE)
(72) Erfinder: Köhler, Friedrich, 86405 Meitingen (DE); Hein, Holger, 86199 Augsburg (DE); Neukam, Wilhelm, 86399 Bobingen (DE); Müller-Augste, Frank, 86399 Bobingen (DE); Scherer, August, 86424 Dinkelscherben (DE)
(74) Vertreter: Epping Hermann & Fischer

(57) **Zusammenfassung**

Die Erfindung betrifft eine Vorrichtung zum Schutz vor elektrostatischer Entladung und elektromagnetischer Einflüsse auf elektronische Komponenten, in einem Gehäuse (B), das ein Element (6), z.B. ein elektrischer Anschluß oder ein Bedienungselement, aufweist, wobei das Element durch ein I/O-Shield (1), welches eine Gehäuseöffnung abdeckt, geführt ist und mit einer Dichtungsschicht (2) abgedichtet ist, wobei die Dichtungsschicht so ausgebildet ist, daß mit den Rändern der Gehäuseöffnung elektrischer Kontakt mit der Dichtungsschicht besteht.

## Beschreibung

Vorrichtung zum Schutz vor elektrostatischer Entladung und elektromagnetischer Einflüsse.

Die Erfindung betrifft eine Vorrichtung zum Schutz vor elektrostatischer Entladung und elektromagnetischer Einflüsse auf elektronische Komponenten, in einem Gehäuse, das ein Element, z.B. ein elektrischer Anschluß oder ein Bedienungselement, aufweist, wobei das Element durch ein I/O-Shield, welches eine Gehäuseöffnung abdeckt, geführt ist und mit einer Dichtungsschicht abgedichtet ist.

Für elektronische Komponenten schädliche elektrostatische Ladungen haben ihren Ursprung sowohl in der Natur als auch in den Menschen, die mit elektronischen Bauelementen und Baugruppen arbeiten, sowie mit Gegenständen, die über Fertigungsprozesse hinweg mehr oder weniger schnell bewegt werden. Elektrostatische Entladungen können an elektronischen Bauteilen Schäden verursachen, die sich oft erst im späteren Betrieb zeigen. Des Weiteren ist bei Geräten mit elektronischen Komponenten eine elektromagnetische Verträglichkeit einzuhalten.

Weist ein elektrisches Gerät bzw. dessen Gehäuse eine Aussparung auf, die dazu dient, elektrische Anschlüsse oder Bedienungselemente nach außen zu führen, so sind diese Gehäuseöffnungen Schwachpunkte in der Abschirmung von elektromagnetischen Feldern und ebenso Schwachpunkte in der Ableitung von elektrostatischen Entladungen. Diesem Problem wird damit begegnet, daß die Gehäuseaussparungen von sogenannten I/O-Shields, die aus leitendem Metall bzw. Blechen bestehen, abgedeckt werden. Der elektrische Anschluß oder das Bedienelement ist dann durch das I/O-Shield hindurch nach außen geführt und wird durch eine elektrisch leitende Dichtung gegenüber elektrostatischer Entladung oder elektromagnetischer Felder abgeschirmt. Nachteilig an diesen Ausführungsvarianten ist, daß die Ableitung elektrostatischer Entladung stets über mehrere Übergangswiderstände erfolgt.

Es bildet sich dabei eine Widerstandskette aus dem Übergangswiderständen:
- Gehäuse - I/O-Shield,
- I/O-Shield - Dichtung und
- Dichtung - elektrischer Anschluß- bzw. Bedienelement.

Die große Zahl der Übergangswiderstände erhöht das Risiko eines zu hohen Übergangswiderstandes und führt somit im ungünstigen Fall zu einer elektrostatischen Entladung über das zu schützende Bauteil.

Es ist die Aufgabe der Erfindung, eine Lösung mit geringeren Übergangswiderständen vorzuschlagen.

Dies wird erreicht, durch eine Vorrichtung zum Schutz vor elektrostatischer Entladung und elektromagnetischer Einflüsse auf elektronische Komponenten, in einem Gehäuse, das ein Element, z.B. ein elektrischer Anschluß oder ein Bedienungselement, aufweist, wobei das Element durch ein I/O-Shield, welches eine Gehäuseöffnung abdeckt, geführt ist und mit einer Dichtungsschicht abgedichtet ist, wobei die Dichtungsschicht so ausgebildet ist, daß mit den Rändern der Gehäuseöffnung elektrischer Kontakt besteht.

Vorteilhaft an der erfindungsgemäßen Ausführungsform ist, durch den elektrischen Kontakt zwischen Dichtungsschicht und Gehäuseaussenseite oder Innenseite und/oder der Wandung der Gehäuseöffnung, die Verringerung der Übergangswiderstandskette um den Übergangswiderstand von:
- Gehäuse - I/O-Shield.

Ableitungen elektrostatischer Entladungen erfolgen direkt über die elektrisch leitende Dichtungsschicht und das Gehäuse. Somit verbleiben nur zwei Übergangswiderstände bei einer erfindungsgemäßen Ausführung, nämlich der Übergangswiderstand
- elektrisch leitende Dichtung - Gehäuse und
- elektrisch leitende Dichtung - Stecker bzw. elektrischer Anschluß oder Bedienelement.

In einer weiteren vorteilhaften Ausführungsform ist die elektrisch leitende Dichtungsschicht nicht nur formschlüssig mit der Gehäuseöffnung, sondern überschreitet die Maße der Gehäuseöffnung so, daß bei einer Befestigung des I/O-Shields von Gehäuseaußenseite oder Gehäuseinnenseite her, die elektrisch leitende Dichtung sich zwischen I/O-Shield und Gehäuse preßt. Damit verringert sich der Übergangswiderstand zwischen Gehäuse und elektrisch leitender Dichtungsschicht vorteilhaft.

In einer weiteren Ausführungsform wird der Form der Gehäuseöffnung dadurch Rechnung getragen, daß das I/O-Shield U-förmig oder wannenförmig ausgebildet ist. Dies führt zu einer verbesserten Abschirmung und Schutz vor elektrostatischen Entladungen oder elektromagnetischen Feldern und berücksichtigt dabei die bestehende Bauform des elektrischen Anschlusses oder des Bedienungselementes. Das heißt, ein solches I/O-Shield kann ohne weitere Änderungen an den bestehenden Gehäusen und elektronischen Komponenten und deren Bedienungselemente oder elektrischen Anschlüsse verwendet werden und erweitert die Möglichkeiten der Einbauvariationen elektronischer Komponenten.

Im Folgenden ist die Erfindung unter der Bezugnahme auf drei Figuren gegenüber dem Stand der Technik näher erläutert. Es zeigen:
- Figur 1:: eine Vorrichtung zur Abschirmung von elektrostatischen Entladungen und elektromagnetischen Feldern mit einem Federblech nach dem Stand der Technik.
- Figur 2:: eine Vorrichtung zur Abschirmung von elektrostatischen Entladungen und elektromagnetischen Feldern mit einem ebenen Blech nach dem Stand der Technik.
- Figur 3:: eine erfindungsgemäße Vorrichtung zur Abschirmung von elektrostatischen Entladungen und elektromagnetischen Feldern.

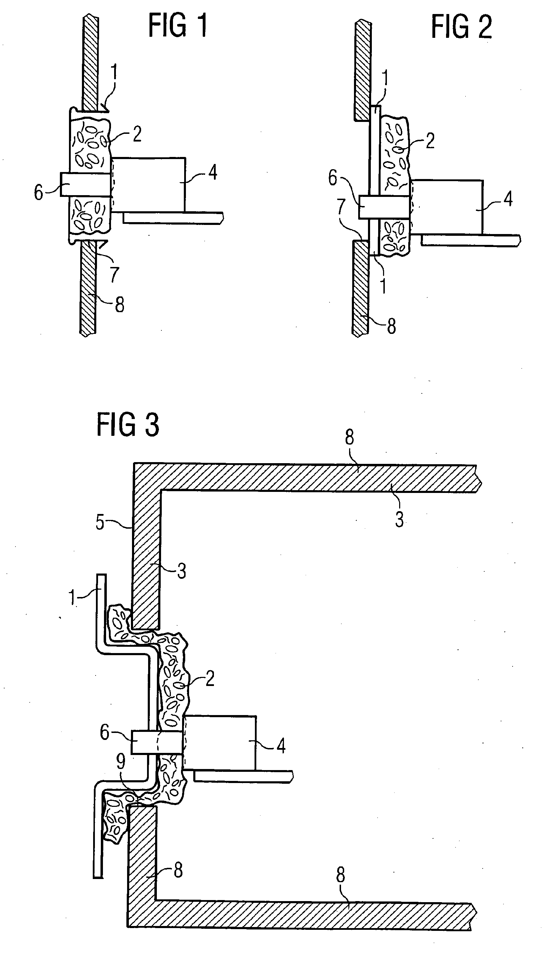

Figur 1 zeigt eine Vorrichtung zum Schutz vor elektrostatischer Entladung und elektromagnetischer Einflüsse auf elektronische Komponenten nach dem Stand der Technik, wobei die Gehäuseöffnung 7 durch ein Federblech als I/O-Shield 1 formschlüssig ausgefüllt wird. Die Durchführung des elektrischen Anschlusses 6, bzw. des Bedienelementes 6 erfolgt durch das Federblech hindurch. Dabei ist diese Durchführung mit einer Dichtung 2 gegenüber elektrostatischer Entladung oder elektromagnetischer Felder abgedichtet. Bei zum Beispiel einer Berührung des elektischen Anschluß mit einem elektrostatisch geladenen Körper, erfolgt die Entladung über die Übergangswiederstandskette:
- Gehäuse 8 - I/O-Shield 1,
- I/O-Shield 1 - Dichtung 2 und
- Dichtung 2 - elektrischer Anschluß- 6 bzw. Bedienelement 6.

Desgleichen geschieht bei der in Figur 2 abgebildeten Vorrichtung zum Schutz vor elektrostatischer Entladung und elektromagnetischer Einflüsse auf elektronische Komponenten nach dem Stand der Technik. Hierbei wird ein I/O-Shield 1 aus elektrisch leitendem Blech ausgebildet, wobei die Abmessungen des I/O-Shields 1 die der Gehäuseöffnung 7 überschreiten.

Figur 3 zeigt die erfindungsgemäße Vorrichtung zum Schutz vor elektrostatischer Entladung und elektromagnetischer Einflüsse auf elektronische Komponenten wobei das I/O-Shield 1 an die Gehäuseaussparung 7 angebracht und die Dichtungsschicht 2 zwischen Gehäuse 8 und I/O-Shield 1 angeordnet ist. Dabei ist die elektrisch leitende Dichtung 2 nicht nur wie im Stand der Technik zur Abdichtung des elektrischen Anschlusses 6 oder Bedienelementes 6 gegenüber dem I/O-Shield 1, sondern in vorteilhafter Weise auch zur Abdichtung gegenüber dem I/O-Shield 1 und der Gehäuseaussparung 7 angebracht.

Dies wird erreicht dadurch, daß zwischen das I/O-Shiel 1 und die Gehäusewand 3 bei der Montage eine elektrisch leitende Dichtung 2 zwischengelegt wird. Diese umfaßt die Gehäuseaussparung 7 zumindest so, daß auf die gesamten Ränder der Gehäuseaussparung 7 eine elektrisch leitende Verbindung mit der elektrisch leitenden Dichtung 2 besteht.

Der elektrische Anschluß 6 oder das Bedienungselement 6 wird durch das I/O-Shield geführt und mit elektrisch leitender Dichtung 2 gegenüber elektrostatischer Entladung und elektromagnetischer Felder abgedichtet bzw. abgeschirmt.

## Patentansprüche

1. Vorrichtung zum Schutz vor elektrostatischer Entladung und elektromagnetischer Einflüsse auf elektronische Komponenten, in einem Gehäuse (8), das ein Element (6), z.B. ein elektrischer Anschluß oder ein Bedienungselement, aufweist, wobei das Element (6) durch ein I/O-Shield (1), welches eine Gehäuseöffnung (7) abdeckt, geführt ist und mit einer Dichtungsschicht (2) abgedichtet ist,
**dadurch gekennzeichnet, daß**
die Dichtungsschicht (2) so ausgebildet ist, daß mit den Rändern der Gehäuseöffnung (7) elektrischer Kontakt besteht.

2. Vorrichtung zum Schutz vor elektrostatischer Entladung und elektromagnetischer Einflüsse nach Patentanspruch 1,
**dadurch gekennzeichnet, daß**
an den Wandungen (9) der Gehäuseöffnung (7) elektrischer Kontakt mit der Dichtungsschicht (2) besteht.

3. Vorrichtung zum Schutz vor elektrostatischer Entladung und elektromagnetischer Einflüsse nach Patentanspruch 1,
**dadurch gekennzeichnet, daß**
an der Gehäuseaussenseite (5) elektrischer Kontakt mit der Dichtungsschicht (2) besteht.

4. Vorrichtung zum Schutz vor elektrostatischer Entladung und elektromagnetischer Einflüsse nach Patentanspruch 1,
**dadurch gekennzeichnet, daß**
an der Gehäuseinnenseite (10) elektrischer Kontakt mit der Dichtungsschicht (2) besteht.

5. Vorrichtung zum Schutz vor elektrostatischer Entladung und elektromagnetischer Einflüsse nach einem der vorhergehenden Patentansprüche,
**dadurch gekennzeichnet, daß**
die Dichtungsschicht (2) aus elektrisch leitendem Material besteht.

6. Vorrichtung zum Schutz vor elektrostatischer Entladung und elektromagnetischer Einflüsse nach einem der vorhergehenden-Patentansprüche,
**dadurch gekennzeichnet, daß**
die Dichtungsschicht aus leicht formbarem elektrisch leitendem Material besteht.

7. Vorrichtung zum Schutz vor elektrostatischer Entladung und elektromagnetischer Einflüsse nach einem der vorhergehenden Patentansprüche,
**dadurch gekennzeichnet, daß**
die Dichtungsschicht zwischen dem Gehäuse und dem I/O-Shield angeordnet ist.

8. Vorrichtung zum Schutz vor elektrostatischer Entladung und elektromagnetischer Einflüsse nach einem der vorhergehenden Patentansprüche,
**dadurch gekennzeichnet, daß**
die Abessungen der Dichtungsschicht (2) über die Abmessungen der Gehäuseöffnung (7) hinausragen.

9. Vorrichtung zum Schutz vor elektrostatischer Entladung und elektromagnetischer Einflüsse nach einem der vorhergehenden Patentansprüche,
**dadurch gekennzeichnet, daß**
das I/O-Shield (6) eine U-förmige Ausbildung aufweist.

10. Vorrichtung zum Schutz vor elektrostatischer Entladung und elektromagnetischer Einflüsse nach einem der vorhergehenden Patentansprüche,
**dadurch gekennzeichnet, daß**
das I/O-Shield eine wannenförmige Ausbildung aufweist.
